# EUROPÄISCHE PATENTSCHRIFT

(11) **EP 2 585 841 B1**
(45) Veröffentlichungstag und Bekanntmachung des Hinweises auf die Patenterteilung: **09.09.2015**
(21) Anmeldenummer: 10725802.2
(22) Anmeldetag: 28.06.2010
(51) Int. Cl.: G01R 31/26, G08B 13/14, H01L 31/02

(54) **VORRICHTUNG UND VERFAHREN ZUR ÜBERWACHUNG EINER PHOTOVOLTAIKANLAGE**
DEVICE AND METHOD FOR MONITORING A PHOTOVOLTAIC SYSTEM
DISPOSITIF ET PROCÉDÉ DE SURVEILLANCE D'UNE INSTALLATION PHOTOVOLTAÏQUE

(43) Veröffentlichungstag der Anmeldung: 01.05.2013
(73) Patentinhaber: SMA Solar Technology AG, 34266 Niestetal (DE)
(72) Erfinder: HOPF, Markus, 34314 Espenau (DE); BEHRENDS, Holger, 34128 Kassel (DE); BETTENWORT, Gerd, 34119 Kassel (DE); BIENIEK, Sebastian, 34266 Niestetal (DE); KRATOCHVIL, Marcel, 34119 Kassel (DE)
(74) Vertreter: Kleine, Hubertus
(86) Internationale Anmeldenummer: PCT/EP2010/059128
(87) Internationale Veröffentlichungsnummer: WO 2012/000533

(56) Entgegenhaltungen:
- EP-A1- 1 918 727
- WO-A1-95/25374
- WO-A1-2008/043814
- WO-A1-2009/026602
- DE-A1-102006 034 223
- DE-A1-102008 062 659

## Beschreibung

Die Erfindung betrifft eine Vorrichtung und ein Verfahren zur Überwachung einer Photovoltaikanlage.

Eine Photovoltaikanlage stellt mittels Photovoltaik elektrische Energie zur Verfügung.

Im Betrieb der Photovoltaikanlagen können hohe elektrische Ströme auftreten, welche u. U. im Zusammenwirken mit defekten und/oder schadhaften Komponenten der Photovoltaikanlage zu erheblichen Leistungsverlusten führen können. Dies betrifft insbesondere Kontaktwiderstände von Kontakten von Verbindungsstellen von Modulen untereinander wie auch elektrische Leitungsanschlüsse.

Um einen bestimmungsgemäßen Betrieb zu gewährleisten, ist es erforderlich, photovoltaische Anlagen zu überwachen, um das Auftreten von den bestimmungsgemäßen Betrieb der Einrichtung beeinträchtigenden Ereignissen zu erkennen.

Derartige Ereignisse können beispielsweise sein:
- Diebstahl einzelner oder mehrerer Komponenten einer Photovoltaikanlage,
- Zerstörung einzelner oder mehrerer Komponenten einer Photovoltaikanlage,
- Veränderung der Leitfähigkeit einer oder mehrerer elektrischer Verbindungen einer Photovoltaikanlage (beispielsweise eine Kontaktalterung und/oder ein Kontaktfehler),
- Verschlechterung eines Wirkungsgrads einer oder mehrerer Photovoltaikmodule (Degradation),
- Installationsfehler, beispielsweise eine fehlerhafte Verschaltung einzelner oder mehrerer Komponenten bei der Installation einer Photovoltaikanlage, und/oder
- Verschattung, beispielsweise einer Verschattung einzelner oder mehrerer Photovoltaikmodule einer Photovoltaikanlage.

Die vorstehende Auflistung von Ereignissen, die einen bestimmungsgemäßen Betrieb einer Photovoltaikanlage beeinträchtigen können, erhebt keinen Anspruch auf Vollständigkeit, vielmehr stellt sie eine beispielhafte Auswahl von Ereignissen dar, die einen bestimmungsgemäßen Betrieb einer Photovoltaikanlage beeinträchtigen können.

Aus der Druckschrift WO 2008/043814 A1 ist eine Photovoltaikanlage bekannt, bei der über einen Pulsgenerator Pulse in Photovoltaikgenerator eingekoppelt werden. Der Photovoltaikgenerator weist verschiedene, als sogenannte Strings verschaltete Gruppen von Photovoltaikmodulen auf. Jeder String ist über einen Vorwiderstand mit einem Optokoppler verbunden, über den die eingespeisten Pulse detektiert werden können. Ein fehlendes Signal an einem der Optokoppler kann auf einen Diebstahl von Teilen des zugeordneten Strings hinweisen. Das Betreiben der Optokoppler über einen Vorwiderstand ist bei hohen an den Strings bereitgestellten Spannungen jedoch verlustreich

Eine weitere Vorrichtung zum Erkennen eines Diebstahls eines Photovoltaikgenerators ist in der Druckschrift DE 10 2008 062 659 A1 beschrieben. Hierbei wird eine in ihrer Frequenz veränderbare Wechselspannung in den Photovoltaikgenerator eingekoppelt Anhand einer induktiv oder kapazitiv ausgekoppelten Wechselspannung werden Hochfrequenz-Eigenschaften des Photovoltaikgenerators ermittelt. Änderungen der Hochfrequenz-Eigenschaften zeigen einen Diebstahl oder eine Beschädigung mindestens eines Photovoltaikmoduls an.

In ähnlicher Weise werden gemäß der Druckschrift EP 1 918 727 A1 wiederholt Impedanzkurven eines Photovoltaikgenerators einer Photovoltaikanlage ermittelt. Aus Veränderungen der Impedanzkurven kann auf einen Diebstahl geschlossen werden. In einer Ausgestaltung erfolgt eine Ein- bzw. Auskopplung eines zur Ermittlung der Impedanzkurven verwendeten Wechselstromsignals über Übertrager, die mit jeweils einer Wicklung in einen Gleichstromkreis des Photovoltaikgenerators eingeschleift sind.

Gemäß der Druckschrift WO 2009/026602 A1 werden in einen Photovoltaikgenerator charakteristische Pulsfolgen von Wechsel- oder Gleichstromsignalen ein- und wieder ausgespeist, anhand derer eine Diebstahlserkennung vorgenommen wird.

Die vorliegende Erfindung zielt darauf ab, die Überwachung des bestimmungsgemäßen Betriebs einer zwei oder mehr Photovoltaikmodule aufweisenden Photovoltaikanlage zu verbessern, wobei eine verlustarme und Gruppen-selektive Erkennung von Ereignissen erfolgen soll.

Die Erfindung erreicht dieses Ziel mit einer Vorrichtung entsprechend dem Anspruch 1 und einem Verfahren nach Anspruch 12.

Geschaffen wird eine Vorrichtung zur Überwachung einer Photovoltaikanlage zur Erkennung des Auftretens von den bestimmungsgemäßen Betrieb der Photovoltaikanlage beeinträchtigenden Ereignissen. Die Vorrichtung umfasst einen photovoltaischen Generator mit einer ersten Gruppe von Photovoltaikmodulen und einer zweiten Gruppe von Photovoltaikmodulen, die von der ersten Gruppe verschieden ist Weiter umfasst die Vorrichtung ein erstes und ein zweites Kopplungsmittelpaar, beide Paare umfassend Signaleinkopplungsmittel zur Einkopplung eines Testsignals in den photovoltaischen Generator, und ein Signalauskopplungsmittel zur Auskopplung eines Antwortsignals, wobei das Signaleinkopplungsmittel und/oder das Signalauskopplungsmittel des ersten Kopplungsmittelpaars derart angeordnet ist, dass es das Auftreten der Ereignisse selektiv in der ersten Gruppe von Photovoltaikmodulen erkennen kann, und das Signaleinkopplungsmittel und/oder das Signalauskopplungsmittel des zweiten Kopplungsmittelpaars derart angeordnet ist, dass es das Auftreten der Ereignisse selektiv in der zweiten Gruppe von Photovoltaikmodulen erkennen kann. Dabei wird das Signaleinkopplungsmittel des ersten Kopplungsmittelpaars von dem durch die erste Gruppe von Photovoltaikmodulen fließenden Gleichstrom durchflossen und es wird das Signaleinkopplungsmittel des zweiten Kopplungsmittelpaars von dem durch die zweite Gruppe von Photovoltaikmodulen fließenden Gleichstrom durchflossen.

Jedes Kopplungsmittelpaar dient dem Einspeisen des Testsignals und dem Auskoppeln des entsprechenden Antwortsignals, aus dem auf ein den bestimmungsgemäßen Betrieb beeinträchtigenden Ereignis geschlossen werden kann. Die Aufteilung des photovoltaischen Generators in die mindestens zwei Gruppen und die individuelle Überwachung der beiden Gruppen durch die mindestens zwei Kopplungsmittelpaare erlaubt zum Einen eine Lokalisierung des beeinträchtigenden Ereignisses. Zum Anderen ergibt sich eine bessere Skalierbarkeit bei wachsender Anlagengröße. Unter Verwendung gleicher Komponenten (z.B. Signaleinkopplungsmittel, Signalauskopplungsmittel) kann die Vorrichtung zur Überwachung an Photovoltaikanlagen beliebiger Größe durch Aufteilung in eine entsprechende Anzahl von Gruppen angepasst werden. Ein weiterer Vorteil betrifft messtechnische Aspekte. Durch die Gruppenaufteilung steigt die relative Größe des einem beeinträchtigenden Ereignis zuzuordnenden Anteils am Antwortsignal. Gleichzeitig werden durch die Gruppenaufteilung sowohl Störsignale als auch Rauschanteile effektiv reduziert. Somit kann das Ereignis zuverlässiger detektiert werden.

In einer vorteilhaften Ausgestaltung der Vorrichtung wird auch das Signalauskopplungsmittel des ersten Kopplungsmittelpaars von dem durch die ersten Gruppe von Photovoltaikmodulen fließenden Gleichstrom durchflossen und das Signalauskopplungsmittel des zweiten Kopplungsmittelpaars wird von dem durch die zweite Gruppe von Photovoltaikmodulen fließenden Gleichstrom durchflossen.

In einer weiteren vorteilhaften Ausgestaltung der Vorrichtung ist das Signaleinkopplungsmittel des ersten Kopplungsmittelpaares identisch mit dem Signaleinkopplungsmittel des zweiten Kopplungsmittelpaares. In einer weiteren vorteilhaften Ausgestaltung ist das Signalauskopplungsmittel des ersten Kopplungsmittelpaares identisch mit dem Signalauskopplungsmittel des zweiten Kopplungsmittelpaares. Auf diese Weise kann die Vorrichtung unter Beibehaltung der genannten Vorteile, insbesondere der Lokalisierbarkeit und der Skalierbarkeit, mit vermindertem Materialeinsatz realisiert werden.

Geschaffen wird weiter ein Verfahren zur Überwachung einer eine Anzahl von wenigstens zwei oder mehr Photovoltaikmodule aufweisenden Photovoltaikanlage zur Erkennung des Auftretens von den bestimmungsgemäßen Betrieb der Photovoltaikanlage beeinträchtigenden Ereignissen, wobei die Photovoltaikanlage mit wenigstens einem elektrischen Testsignal angeregt wird, das mit wenigstens einem Einkopplungsmittel in die Photovoltaikanlage eingekoppelt wird - Schritt 100 -, wobei wenigstens eine Signalantwort der Photovoltaikanlage auf die Anregung mit wenigstens einem Auskopplungsmittel aus der Photovoltaikanlage ausgekoppelt wird - Schritt 200 -, und wobei die Signalantwort der Photovoltaikanlage auf die Anregung erfasst wird und zur Erkennung des Auftretens wenigstens eines den bestimmungsgemäßen Betrieb der Photovoltaikanlage beeinträchtigenden Ereignisses ausgewertet wird - Schritt 300-. Wenigstens zwei oder mehr Photovoltaikmodule werden in wenigstens zwei oder mehr Gruppen unterteilt, wobei jede der Gruppen auf das Auftreten eines den bestimmungsgemäßen Betrieb der Photovoltaikanlage überwacht wird. Das Verfahren zeichnet sich dadurch aus, dass das Einkopplungsmittel von dem durch die Photovoltaikmodule der jeweiligen Gruppen fließenden Gleichstrom durchflossen wird.

Die Erfindung optimiert die Überwachung einer zwei oder mehr Photovoltaikmodule aufweisende Photovoltaikanlage, indem sie das lokalisierte Erkennen von einem oder mehreren den bestimmungsgemäßen Betrieb der Photovoltaikanlage beeinträchtigenden Ereignissen entsprechend der eingangs genannten Aufzählung ermöglicht. Ein solches Ereignis bzw. ein solcher Fehler kann deshalb genauer lokalisiert werden, als wenn nur eine Überwachung der Gesamtanalage ohne eine Gruppenunterteilung erfolgt. Damit wird in vorteilhafter Weise eine Möglichkeit zu einer umfänglichen Überwachung von photovoltaischen Anlagen geschaffen. Die Sicherstellung eines bestimmungsgemäßen Betriebs derartiger Anlagen und die damit einhergehende zuverlässige Bereitstellung elektrischer Energie werden deutlich vereinfacht.

Es ist vorteilhaft, wenn entweder einer oder beide der Schritte 100 und 200 je Gruppe separat durchgeführt werden. Werden beide der Schritte 100 je Gruppe separat ausgeführt, ist die Überwachung besonders präzise. Die beiden hierzu alternativen Ausgestaltungen verringern demgegenüber den schaltungstechnischen Aufwand.

Weitere vorteilhafte Ausgestaltungen und Weiterbildungen der Vorrichtung und des Verfahrens sind in den jeweiligen Unteransprüchen angegeben.

Nachfolgend wird die Erfindung anhand von Ausführungsbeispielen unter Bezugnahme auf die beiliegenden Zeichnungen näher beschrieben.

Vor der Beschreibung bevorzugter Ausführungsbeispiele sei angemerkt, dass nachfolgend einige bevorzugte Ausgestaltungen auch im Detail beschrieben werden, dass die Erfindung aber nicht auf diese Ausgestaltungen beschränkt ist sondern im Rahmen der Ansprüche beliebig variiert ausgestaltet werden kann. Insbesondere sind Begriffe wie "oben", "unten", "vorne" oder "hinten" nicht einschränkend zu verstehen sondern beziehen sich lediglich auf die jeweils dargestellte Anordnung. Zudem sind, wenn einzelne Bestandteile erläutert werden, diese - wenn nicht anders erwähnt - grundsätzlich auch in mehrfacher Ausgestaltung denkbar. Unter den Schutzbereich fallen zudem auch funktionale Umkehrungen der dargestellten Anordnungen und Verfahren sowie äquivalente Ausgestaltungen.

Es zeigen:
- Fig. 1: beispielhaft eine schematische Darstellung einer zur überwachenden Photovoltaikanlage in Form eines Blockschaltbilds,
- Fig. 2: beispielhaft eine erste Ausführungsform der Erfindung in Form eines vereinfachten elektrischen Schaltbilds,
- Fig. 3: beispielhaft eine zweite Ausführungsform der Erfindung in Form eines vereinfachten elektrischen Schaltbilds,
- Fig. 4: beispielhaft eine dritte Ausführungsform der Erfindung in Form eines vereinfachten elektrischen Schaltbilds,
- Fig. 5: beispielhaft eine vierte Ausführungsform der Erfindung in Form eines vereinfachten elektrischen Schaltbilds,
- Fig. 6: beispielhaft eine fünfte Ausführungsform der Erfindung in Form eines vereinfachten elektrischen Schaltbilds,
- Fig. 7: beispielhaft eine sechste Ausführungsform der Erfindung in Form eines vereinfachten elektrischen Schaltbilds,
- Fig. 8: beispielhaft eine siebte Ausführungsform der Erfindung in Form eines vereinfachten elektrischen Schaltbilds, und
- Fig. 9: beispielhaft eine achte Ausführungsform der Erfindung in Form eines vereinfachten elektrischen Schaltbilds;
- Fig. 10: beispielhaft eine neunte Ausführungsform der Erfindung in Form eines vereinfachten elektrischen Schaltbilds;
- Fig. 11: ein Flussdiagramm zur Veranschaulichung eines Überwachungsverfahrens; und;
- Fig. 12: ein weiteres Flussdiagramm zur Veranschaulichung eines erfindungsgemäßen Überwachungsverfahrens.

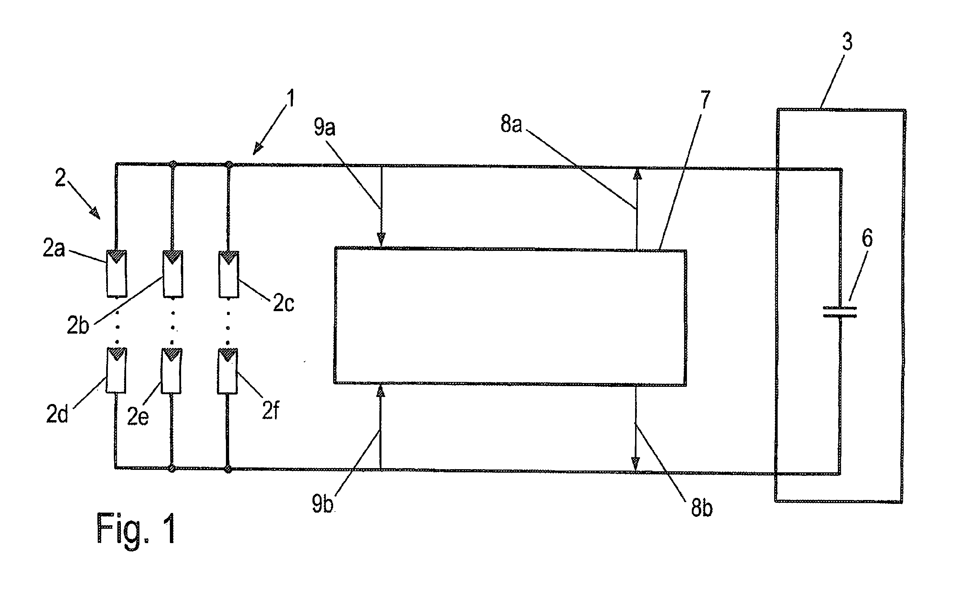

Fig. 1 zeigt beispielhaft eine Photovoltaikanlage 1 in Form eines elektrischen Schaltbildes. Die Photovoltaikanlage 1 weist einen photovoltaischen Generator 2 (im Folgenden auch als Photovoltaikgenerator 2 bezeichnet) auf, der seinerseits eine Anzahl von Photovoltaikmodulen 2a bis 2f aufweist.

Als Photovoltaikgenerator 2 wird im Rahmen dieser Anmeldung der Teil der Photovoltaikanlage 1 bezeichnet, der Strahlungsenergie in elektrische Energie umwandelt. Ein Photovoltaikgenerator 2 kann nur ein einziges Photovoltaikmodul bis hin zu einer sehr großen Anzahl von Photovoltaikmodulen 2a - 2f aufweisen. Diese Photovoltaikmodule 2a - 2f können innerhalb des Photovoltaikgenerators 2 auf verschiedenste Weise verschaltet und/oder angeordnet sein. Beispielhaft sind im Ausführungsbeispiel der Figur 1 jeweils mehrere Photovoltaikmodule in Reihe zu je einem sogenannten String verschaltet, wobei der Übersichtlichkeit halber jeweils nur zwei Photovoltaikmodule 2a und 2d, 2b und 2e bzw. 2c und 2f pro String dargestellt sind. Insgesamt sind hier drei Strings gebildet, die parallel geschaltet den Photovoltaikgenerator 2 darstellen.

Weiterhin weist die Photovoltaikanlage 1 wenigstens einen Wechselrichter 3 auf, der eine von dem Photovoltaikgenerator 2 über elektrische Leitungen bereitgestellte elektrische Leistung wandelt und/oder aufbereitet und zwar derart, dass die gewandelte und/oder aufbereitete elektrische Leistung in ein - nicht dargestelltes - elektrisches Netz, beispielsweise das öffentliche Stromversorgungsnetz eingespeist werden kann.

Eine Kapazität 6 symbolisiert das Wechselstromverhalten des Wechselrichters 3 für höherfrequente Wechselspannungen.

Eine mit dem Bezugszeichen 7 bezeichnete Überwachungsvorrichtung (beispielsweise eine mit den erforderlichen Mitteln ausgestattete Signalgenerator- und Signalverarbeitungseinrichtung, die eine Steuereinrichtung aufweist) ist zunächst dazu ausgelegt, die Photovoltaikanlage 1 über elektrische Verbindungen als Einkopplungswege 8a, 8b und Auskopplungswege 9a, 9b (galvanischer und/oder nicht galvanischer Art) - symbolhaft als Linien dargestellt - mit wenigstens einem Testsignal anzuregen.

Die Überwachungsvorrichtung 7 ist ferner dazu ausgelegt, wenigstens eine Signalantwort der Photovoltaikanlage 1 auf die Anregung mit dem wenigstens einen Testsignal zu erfassen.

Darüber hinaus ist die Überwachungsvorrichtung 7 auch dazu ausgelegt, diese Signalantwort auszuwerten. So kann sie dazu ausgelegt sein, die Signalantwort zur Erkennung des Auftretens wenigstens eines den bestimmungsgemäßen Betrieb der Photovoltaikanlage 1 beeinträchtigenden Ereignis (vgl. oben) zu verwenden, um beispielsweise ein Alarmsignal auszugeben, wenn der Betrieb gestört ist.

So kann mit Hilfe eines Testsignals mit veränderlicher Frequenz, welches in die Elektrik der Photovoltaikanlage eingekoppelt und in Form eines Antwortsignals wieder aus dieser ausgekoppelt wird, beispielsweise ein fehlerhafter Kontakt erkannt werden, ohne die elektrischen Verbindungen der Photovoltaikanlage auftrennen zu müssen. Hierzu wird das Verhalten der Photovoltaikanlage beispielsweise über einen gewissen Zeitraum erfasst und es werden geeignete den "Normalbetrieb" ohne Fehler charakterisierende Parameter gespeichert.

Abweichungen von den ermittelten Parametern weisen auf mögliche Fehlerzustände hin. Ein Parameter dieser Art kann beispielsweise das Impedanzverhalten der Anlage sein.

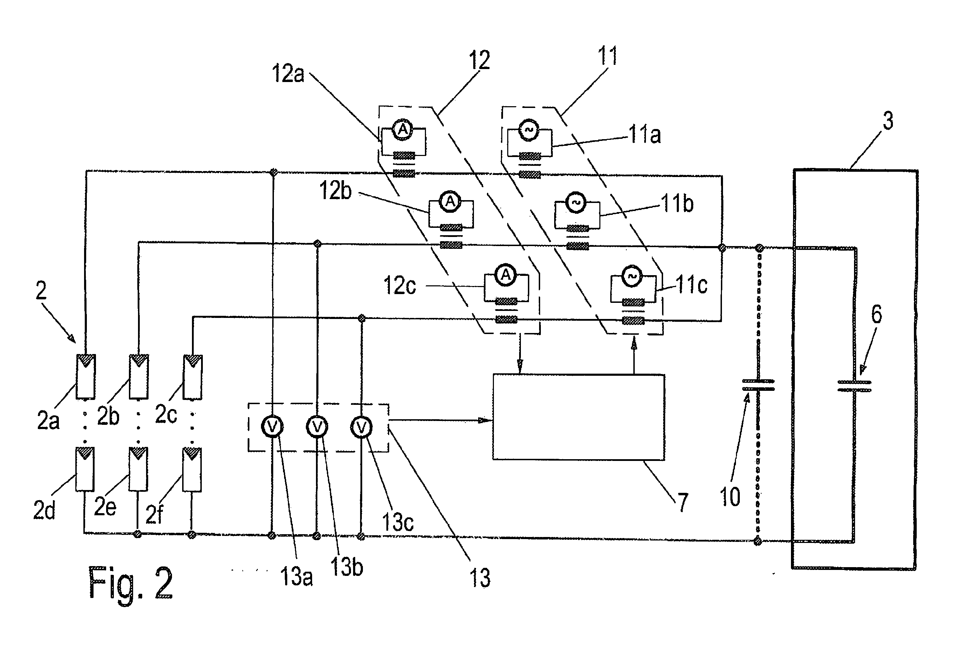

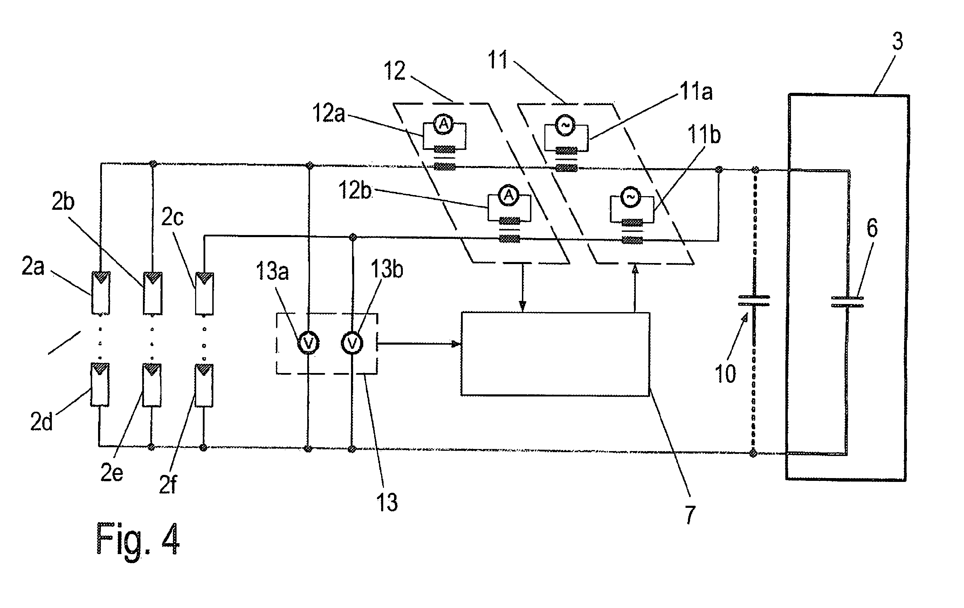

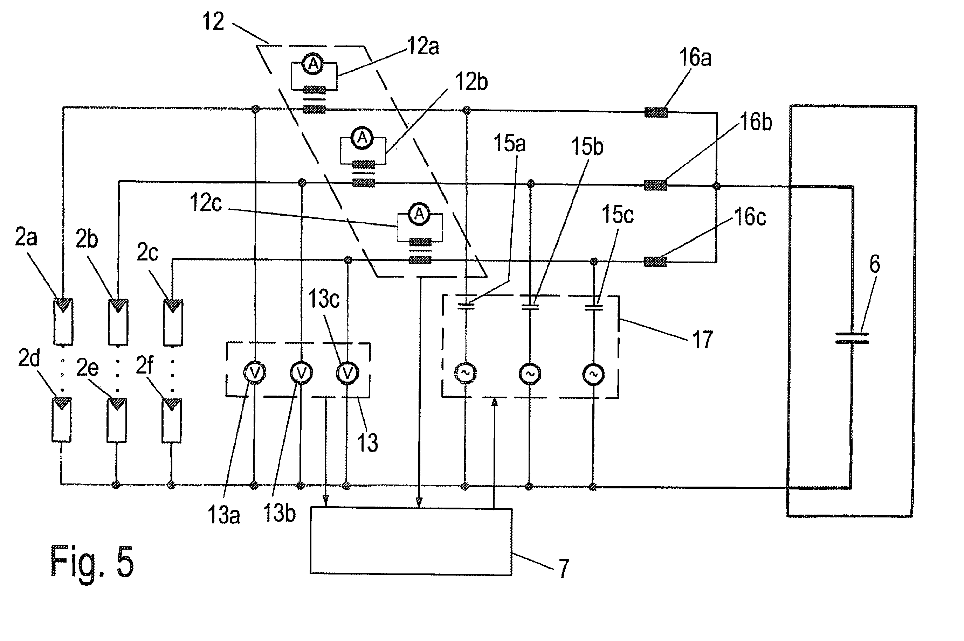

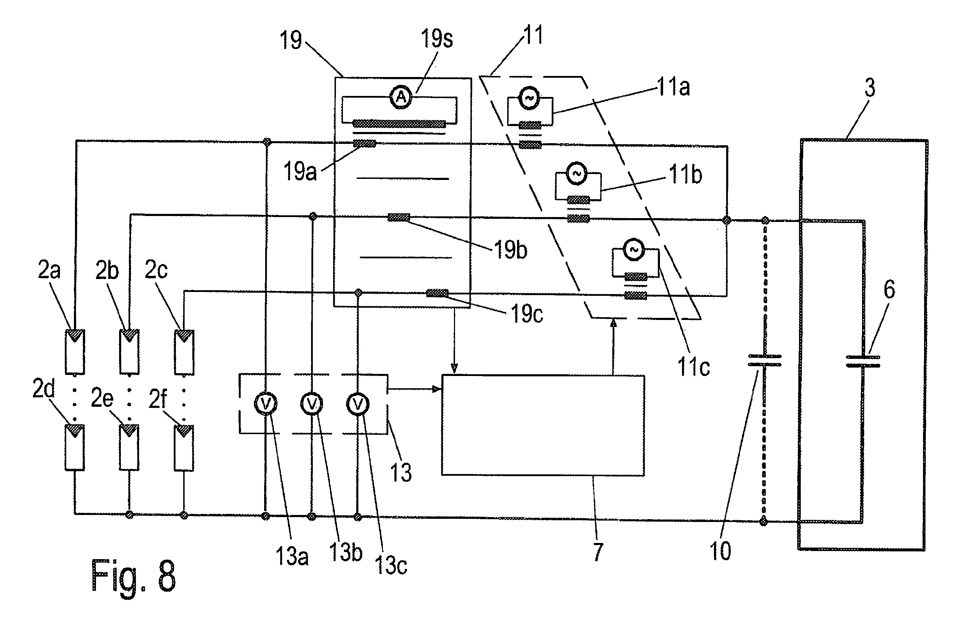

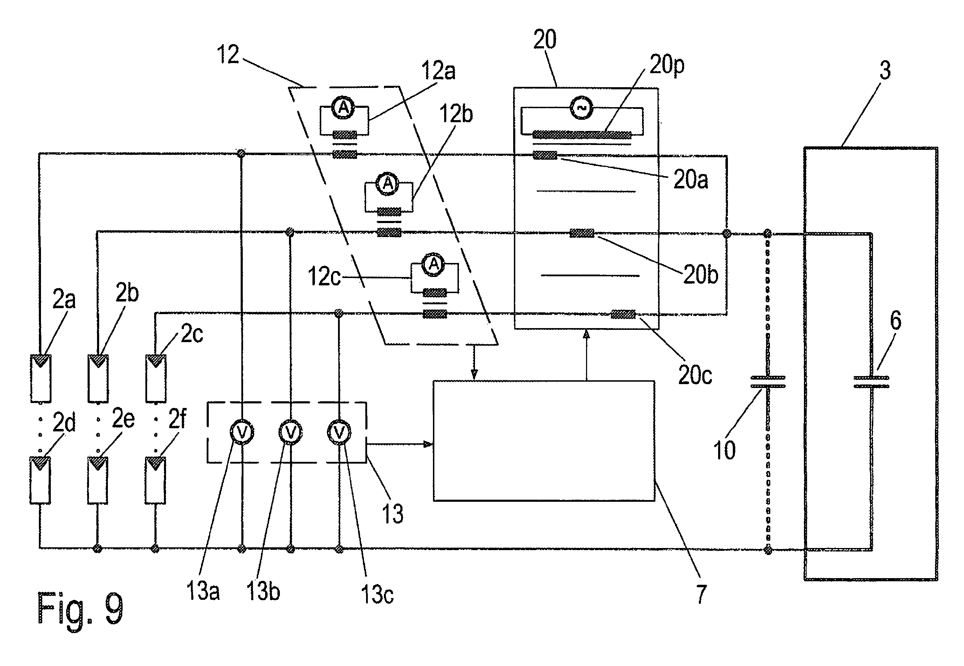

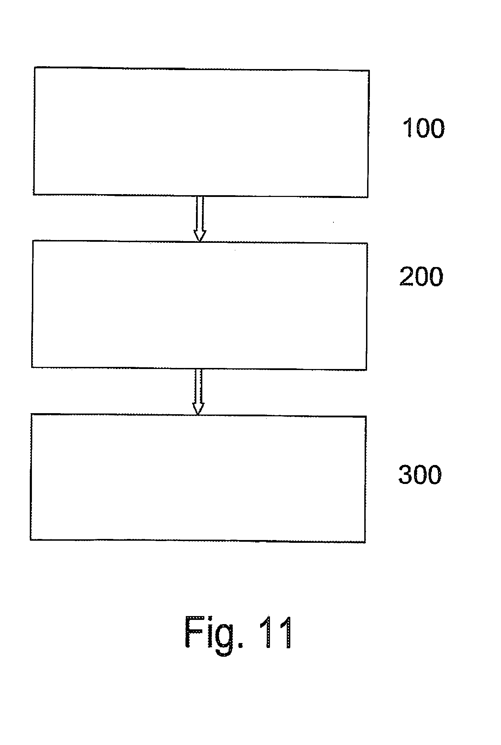

Wie in Fig. 11 vereinfacht dargestellt, wird die Photovoltaikanlage 1 mit wenigstens einem elektrischen Testsignal angeregt, das mit wenigstens einem Einkopplungsmittel 11 (siehe Fig. 2, 3, 4, 8, 10); 15, 17 (siehe Fig. 5, 6, 7) und 20 (siehe Fig. 9) in die Photovoltaikanlage 1 eingekoppelt wird - Schritt 100 -, wobei wenigstens eine Signalantwort der Photovoltaikanlage 1 auf die Anregung mit wenigstens einem Auskopplungsmittel 12 (siehe Fig. 4 bis 7, 9, 10) und 19 (siehe Fig. 8) aus der Photovoltaikanlage 1 ausgekoppelt wird - Schritt 200 -, und wobei die Signalantwort der Photovoltaikanlage 1 auf die Anregung erfasst wird und zur Erkennung des Auftretens wenigstens eines den bestimmungsgemäßen Betrieb der Photovoltaikanlage 1 beeinträchtigenden Ereignisses ausgewertet wird - Schritt 300.

Derart können mit einem einzigen Signaleinkopplungsmittel und einer entsprechenden einzigen Auskopplung und Auswertung Fehlerzustände an einer Photovoltaikanlage ermittelt werden. Nachfolgend wird zudem anhand einiger beispielhafter Ausführungsbeispiele beschrieben, wie dieses Verfahren dazu genutzt werden kann, um Fehlerzustände in dem Photovoltaikgenerator nicht nur generell festzustellen sondern auch näher lokalisieren zu können.

Dabei werden die Photovoltaikmodule 2a bis 2f eines Photovoltaikgenerators 2 in wenigstens zwei oder mehr Gruppen unterteilt und es werden mehr als eine, vorzugsweise sämtliche dieser Gruppen getrennt auf das Auftreten eines den bestimmungsgemäßen Betrieb der Photovoltaikanlage 1 beeinträchtigenden Ereignisses überwacht. Dabei ist klar, dass ein Auftreten eines solchen Ereignisses in einer der überwachten Gruppen den bestimmungsgemäßen Betrieb der gesamten Photovoltaikanlage 1 beeinflussen kann.

Ein erster Vorteil der Erfindung liegt in der guten Skalierbarkeit der zur Durchführung der Erfindung erforderlichen Mittel, d.h. diese können an Photovoltaikgeneratoren beliebiger Größe angepasst werden. Ein weiterer Vorteil liegt in der Möglichkeit, das Auftreten der beeinträchtigenden Ereignisse innerhalb des Photovoltaikgenerators lokalisieren zu können. Weiterhin ist aufgrund des innerhalb einer Gruppe (verglichen mit dem Gesamtstrom) geringeren Stromflusses der Einfluss eines beeinträchtigenden Ereignisses anteilsmäßig größer. Durch die Gruppenaufteilung werden die relativen Anteile von sowohl Störsignalen als auch Rauschanteilen reduziert. Somit kann das Ereignis zuverlässiger detektiert werden.

Gleichzeitig kann die Forderung nach einer möglichst geringen Beeinflussung des Betriebs der photovoltaischen Einrichtung durch das erfindungsgemäße Verfahren erfüllt werden.

Weitere Vorteile werden im Verlauf der weiteren Erläuterung der Erfindung offensichtlich.

Fig. 2 zeigt beispielhaft eine detaillierter dargestellte erste Ausführungsform der Erfindung.

Gezeigt ist wiederum ein Photovoltaikgenerator 2, wobei jeweils zwei dargestellte Photovoltaikmodule 2a und 2d, 2b und 2e sowie 2c und 2f wie in dem Ausführungsbeispiel der Fig. 1 zu einem String zusammengefasst sind.

Weiterhin gezeigt ist der Wechselrichter 3 und dessen Wechselstromersatzkapazität 6. Außerdem ist eine weitere Kapazität 10 dargestellt, die in einer Betriebsart zugeschaltet wird, in der der Wechselrichter 3 außer Betrieb ist (beispielsweise nachts) und daher mit seiner Wechselstromersatzkapazität 6 wechselstrommäßig nicht für einen geschlossenen Stromkreis sorgt.

Jedem der drei Strings, gebildet aus den Photovoltaikmodulen 2a und 2d, 2b und 2e sowie 2c und 2f, ist jeweils ein Kopplungsmittelpaar zugeordnet, mit dem das Auftreten von den bestimmungsgemäßen Betrieb beeinträchtigenden Ereignissen jeweils innerhalb eines Strings erkannt werden kann. Der Photovoltaikgenerator 2 ist somit in verschiedene Gruppen unterteilt, innerhalb derer die genannten Ereignisse selektiv erkannt werden können. In diesem Sinne ist im Rahmen der Anmeldung eine Gruppe als eine Anordnung von Photovoltaikmodulen 2a-2f zu verstehen, der ein Kopplungsmittelpaar zum Erkennen der beeinträchtigenden Ereignissen zugeordnet ist. Die Verschaltung der Photovoltaikmodule einer Gruppe untereinander ist dabei beliebig und nicht auf eine Reihenschaltung wie im Ausführungsbeispiel der Fig. 2 beschränkt.

Ein Kopplungsmittelpaar umfasst Einkopplungsmittel 11 - beispielsweise ein Übertrager 11a, 11b, 11c- zur Einkopplung eines Testsignals in die jeweilige Gruppe, hier dementsprechend den jeweiligen String. Vorzugsweise weisen die Einkopplungsmittel 11 nichtsättigende Bauteile auf, so dass auch dann eine Überwachung erfolgen kann, wenn zwischen dem Photovoltaikgenerator 2 und dem Wechselrichter 3 hohe Gleichströme fließen. Ein Einkopplungsmittel 11 oder jedes Einkopplungsmittel 11 kann einen Signalgenerator mit einer steuerbaren Quelle zur Erzeugung eines Testsignals mit veränderlicher Frequenz aufweisen.

Weiterhin umfasst jedes Kopplungsmittelpaar Signalauskopplungsmittel zur Erfassung eines Antwortsignals. Als Signalauskopplungsmittel sind zum einen Stromwandler 12 zur Bestimmung eines Stromes als Teil der Signalantwort der Strings auf die Anregung mit dem Testsignal vorgesehen- beispielsweise Stromwandler 12a, 12b, 12c.

Vorzugsweise weisen die Stromwandler 12 zur Stromerfassung nichtsättigende Bauteile auf, so dass auch dann eine Überwachung erfolgen kann, wenn zwischen dem Photovoltaikgenerator 2 und dem Wechselrichter 3 hohe Gleichströme fließen.

Zum anderen ist jedem String 2a und 2d, 2b und 2e sowie 2c und 2f als weiterer Teil der Signalauskopplungsmittel eine Spannungsmesseinrichtung 13 vorzugsweise zur Erfassung einer Spannung als Teil der Signalantwort des Strings auf die Anregung mit dem Testsignal zugeordnet - beispielsweise Spannungsmesser 13a, 13b, 13c. Vorzugsweise sind die Spannungsmesser 13a, 13b, 13c hochohmig ausgebildet, um eine Beeinflussung der Funktion der Photovoltaikanlage 1 möglichst gering zu halten bzw. um eine Beeinflussung einer weiteren Ein- bzw. Auskopplungseinrichtung möglichst gering zu halten.

Die gezeigte Schaltungsanordnung gewährleistet außerdem, dass sich die - hier beispielhafte Anzahl von drei - dargestellten Messkreise der Strings 2a und 2d, 2b und 2e sowie 2c und 2f möglichst wenig gegenseitig beeinflussen. Dies wird dadurch erreicht, dass die Induktivitäten der jeweils anderen Messkreise als Sperrinduktivitäten wirken. So verhindern beispielsweise die Induktivitäten des Einkopplungsmittels 11a und des Auskopplungsmittels 12a, dass sich in Folge eines über das Einkopplungsmittel 11b eingekoppeltes Testsignals ein störender Stromfluss über den String 2a und 2d ausbildet. Stattdessen fließt ein derartiger Wechselstrom über die Kapazität 10 bzw. 6, über den String 2b und 2e und über die Kopplungsmittel 12b und 11b.

Die Auswertung erfolgt mittels einer Steuereinrichtung der insgesamt in Fig. 1 mit dem Bezugszeichen 7 bezeichneten Überwachungsvorrichtung, die mit den Einrichtungen 11, 12 und 13 der Fig. 2 zusammenwirkt.

Die beschriebene Anordnung bringt den besonderen Vorteil mit sich, dass jeder String (d.h. jede Gruppe) für sich getrennt überwacht werden kann. Es kann also erkannt werden, in welchem String einer Anzahl von Strings ein Ereignis aufgetreten ist, welches den bestimmungsgemäßen Betrieb der Photovoltaikanlage 1 beeinträchtigt. Durch diese Lokalisierung des Ereignisses kann die oftmals zeitaufwendige Suche nach dem betreffenden String entfallen.

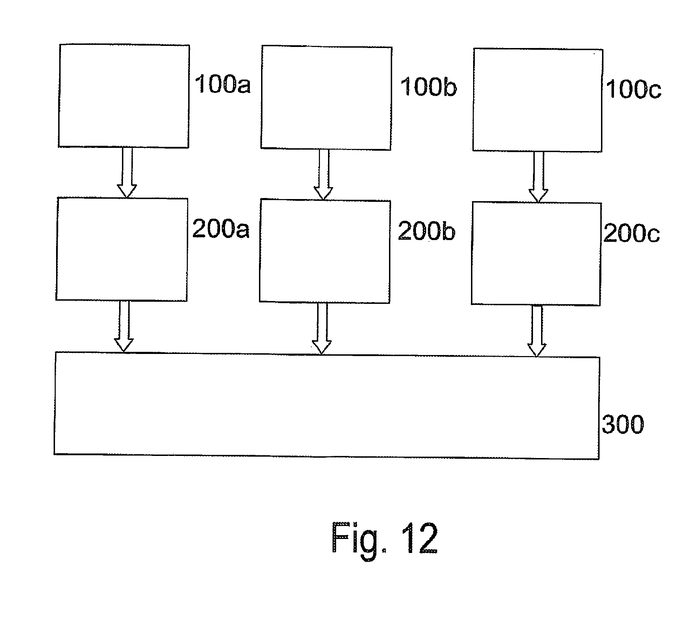

Wie in Fig. 12 dargestellt, werden derart die wenigstens zwei oder mehr Photovoltaikmodule in wenigstens zwei oder mehr Gruppen unterteilt, wobei jede der Gruppen auf das Auftreten eines den bestimmungsgemäßen Betrieb der Photovoltaikanlage 1 überwacht wird.

Dazu wird nach Fig. 2 jede der Gruppen separat mit wenigstens einem elektrischen Testsignal angeregt, das mit wenigstens einem Einkopplungsmittel 11 in die Photovoltaikanlage 1 eingekoppelt wird - Schritt 100 -, wobei ferner separat je Gruppe wenigstens eine Signalantwort der Photovoltaikanlage 1 auf die Anregung mit wenigstens einem Auskopplungsmittel 12, 13 aus der Photovoltaikanlage 1 ausgekoppelt wird - Schritt 200 -, und wobei die jeweilige Signalantwort der Photovoltaikanlage 1 auf die Anregung erfasst wird und zur Erkennung des Auftretens wenigstens eines den bestimmungsgemäßen Betrieb der Photovoltaikanlage 1 beeinträchtigenden Ereignisses ausgewertet wird - Schritt 300.

Nach Fig. 2 werden jeweils beide Schritte 100 und 200 separat für jede der Gruppen durchgeführt. Die Auswertung kann durch eine übergreifende Steuerungseinrichtung in nur einem Schritt 300 oder in mehreren Schritten 300 erfolgen.

Nachfolgend wird deutlich, dass es zu diesem Vorgehen im Rahmen der Erfindung Alternativen gibt, von denen einige näher betrachtet werden sollen, ohne dass die nachfolgende Aufzählung an Beispielen als abgeschlossen zu betrachten ist.
So ist es insbesondere möglich, den Schritt 100 - das Einkoppeln des Testsignals - oder den Schritt 200 - das Auskoppeln des Testsignals - nicht je Gruppe sondern nur einmal für die gesamte Photovoltaikanlage durchzuführen und nur den jeweils anderen Schritt 100 bzw. 200 je Gruppe.

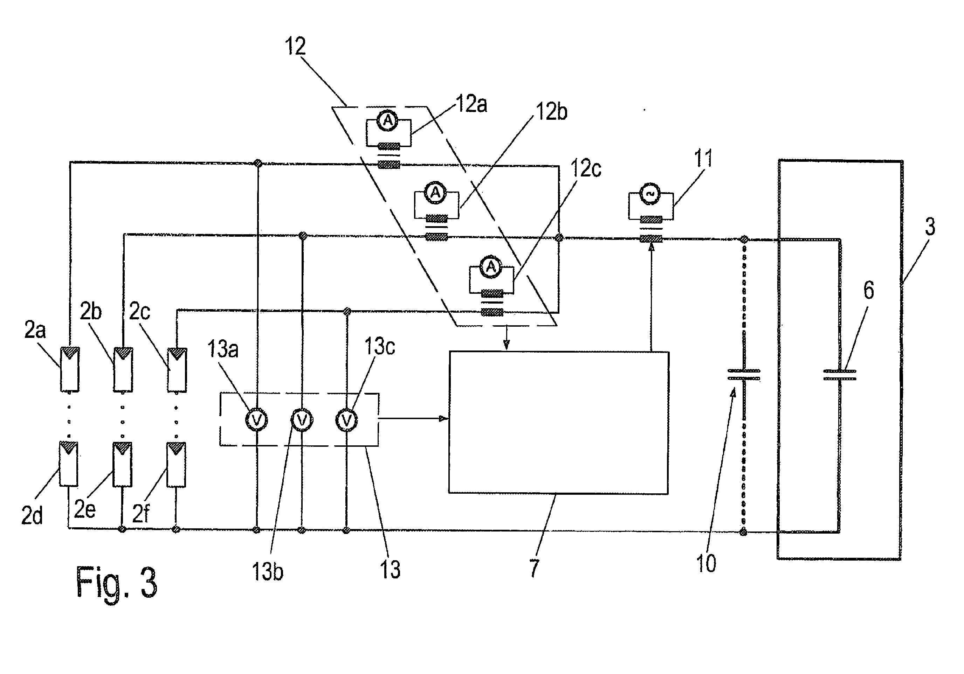

Fig. 3 zeigt eine der Fig. 2 entsprechende Anordnung mit dem Unterschied, dass hier für eine Anzahl von beispielsweise drei Strings 2a, 2d und 2b, 2e sowie 2c, 2f (d. h. für drei Gruppen) ein Übertrager 11 als gemeinsames Einkopplungsmittel vorgesehen ist. Das Einkopplungsmittel ist also für alle Kopplungsmittelpaare identisch, wohingegen die Stromwandler 12a, 12b, 12c und die Spannungsmesser 13a, 13b, 13c als Auskopplungsmittel für die drei Gruppen separat ausgeführt sind. Damit wird Schritt 100 (vgl. Figs. 11 und 12) nur einmal für die gesamte Anlage durchgeführt. Verglichen mit der Ausführungsform der Fig. 2 verringert sich der Hardwareaufwand, dennoch ist eine Lokalisierung des Ereignisses möglich.

In dem in Fig. 4 gezeigten Ausführungsbeispiel ist ein Photovoltaikgenerator 2 in zwei Gruppen unterteilt. Eine erste Gruppe wird von zwei parallelgeschalteten Strings, aufweisend die Photovoltaikmodule 2a, 2d und 2b, 2e, gebildet. Ein weiterer String, gebildet aus den Photovoltaikmodulen 2c, 2f, stellt eine zweite Gruppe dar. Als Einkopplungsmittel ist ein Übertrager 11a und als Auskopplungsmittel sind ein Stromwandler 12a und ein Spannungsmesser13a der ersten Gruppe zugeordnet. Ein weiterer Übertrager 11b, ein weiterer Stromwandler 12b und ein weiterer Spannungsmesser 13b sind der zweiten Gruppe als Ein- bzw. Auskopplungsmittel zugeordnet.

Anders ausgedrückt ist der Photovoltaikgenerator 2 hier derart aufgeteilt, dass eine Gruppe eine Anzahl von parallel geschalteten Strings 2a, 2d / 2b, 2e) aufweist.

Auch bei dieser Variante ist der verringerte Hardwareaufwand vorteilhaft. Dabei wird das Einkopplungsmittel 11, beispielsweise der Übertrager 11a, derart ausgestaltet, dass es eine erforderliche Einkopplungsleistung für die entsprechende Gruppe übertragen kann.

Fig. 5 zeigt eine weitere Ausgestaltung einer Photovoltaikanlage, bei welcher eine Aufteilung des Photovoltaikgenerators 2 in drei Gruppen, hier wie in Fig. 2 durch drei Strings gebildet, vorgenommen wurde.

Im Unterschied zu Fig. 2 erfolgt die Einkopplung eines Testsignals nicht mittels eines Übertragers, sondern mittels einer kapazitiven Einkopplung über eine Koppelkapazität 17, beispielsweise über Einkopplungsmittel 15a, 15b und 15c. Zur Minimierung einer gegenseitigen Beeinflussung der einzelnen Messkreise sind Sperrinduktivitäten 16a, 16b und 16c vorgesehen. Diese übernehmen die Aufgabe, die einzelnen Messkreise wechselstrommäßig zu trennen, wobei sie jeweils in Reihe mit den Stromwandlern 12a, 12b, 12c geschaltet sind. Eine bislang erforderliche Wechselstromersatzkapazität (vgl. Fig.2 bis 4, Bezugszeichen 10) kann entfallen, da der Wechselstromkreis über die Einkopplungsmittel 15a, 15b und 15c der Koppelkapazität 17 geschlossen wird.

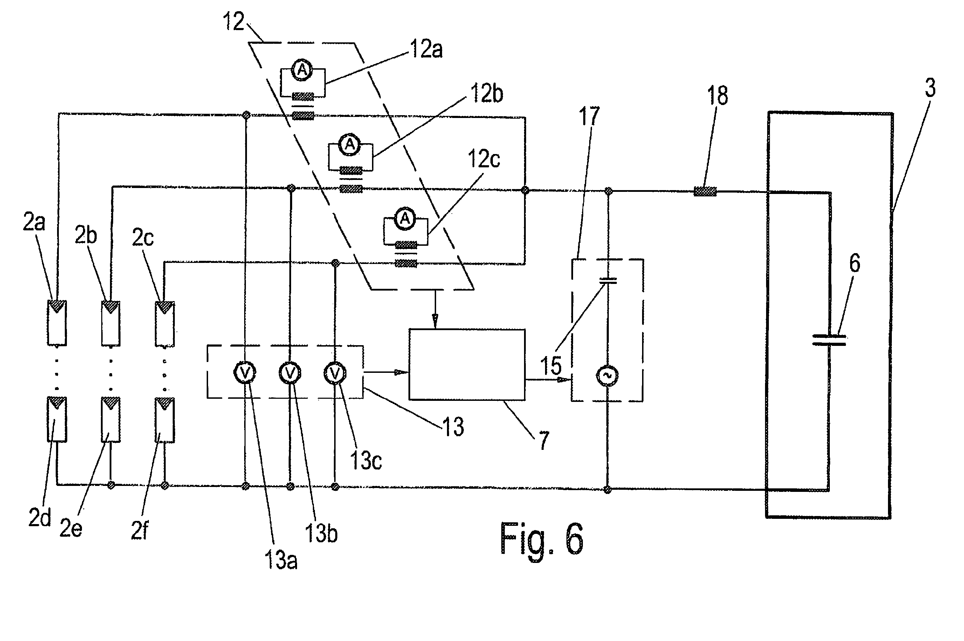

Fig. 6 zeigt eine Anordnung, die weitgehend der in Fig. 5 gezeigten entspricht. Anders als in Fig. 5 erfolgt die Einkopplung eines Testsignals aber gemeinsam über eine kapazitive Einkopplung, über eine gemeinsame Koppelkapazität 17 mit einem Einkopplungsmittel 15.

Für die bereits erläuterte erforderliche Trennung der Messkreise wird eine Sperrinduktivität 18 verwendet. Die Sperrinduktivität 18 ist in der Verbindungsleitung zwischen dem Wechselrichter 3 und einer Verzweigung in die einzelnen Messkreise eingefügt, wobei die Koppelkapazität 17 zur Einkopplung zwischen der Sperrinduktivität 18 und der Verzweigung in die einzelnen Messkreise angeschlossen ist.

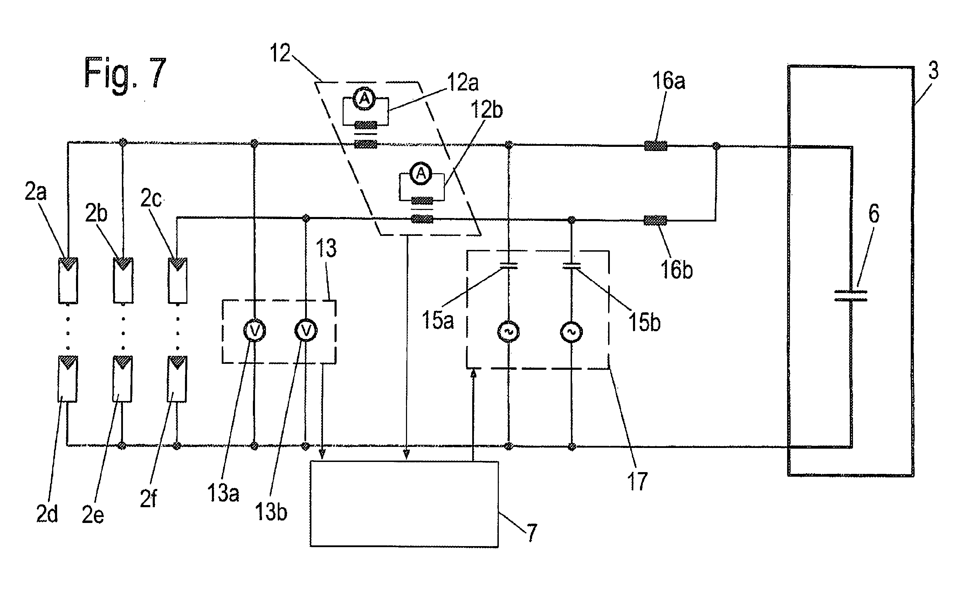

Fig. 7 zeigt eine Anordnung, die wiederum weitgehend der in Fig. 5 gezeigten entspricht. Allerdings sind hier anders als in Fig. 5 wiederum mehrere Strings (hier die Strings 2a, 2d und 2b, 2e) zu einer Gruppe zusammengefasst. Hierbei ist klar, dass der Stromwandler 12a als Auskopplungsmittel, die Sperrinduktivität 16a, sowie das Einkopplungsmittel 15a bzw. die Koppelkapazität 17 hinsichtlich ihrer Bemessung und Auslegung an die entsprechenden Erfordernisse anzupassen sind.

Fig. 8 zeigt eine Ausführung, die im Wesentlichen der bereits in Fig. 2 gezeigten entspricht. Im Unterschied zu der in Fig. 2 gezeigten Anordnung wurden in Fig. 8 die Auskopplungsmittel zur Stromerfassung (vgl. Fig. 2, 12, 12a, 12b, 12c) zu einem übergreifenden einzigen Auskopplungsmittel 19 zusammengefasst. Beispielsweise kann dies durch einen Übertrager mit einer Sekundärwicklung 19s und einer der Anzahl der Messkreise entsprechenden Anzahl von Primärwicklungen 19a, 19b, und 19c erfolgen. Die Spannungsmesser 13a, 13b, 13c als Auskopplungsmittel zur Spannungserfassung sind dagegen separat für jede Gruppe ausgeführt.

Fig. 9 zeigt eine Ausführung, die weitgehend der in Fig. 2 gezeigten entspricht. Im Unterschied zu der in Fig. 2 gezeigten Anordnung wurden in Fig. 8 die Einkopplungsmittel (vgl. Fig. 2, 11, 11a, 11b und 11c) zu einem Einkopplungsmittel 20 zusammengefasst. Beispielsweise kann dies durch einen Übertrager mit einer Primärwicklung 20p und einer der Anzahl der Messkreise entsprechenden Anzahl von Sekundärwicklungen 20a, 20b, und 20c erfolgen.

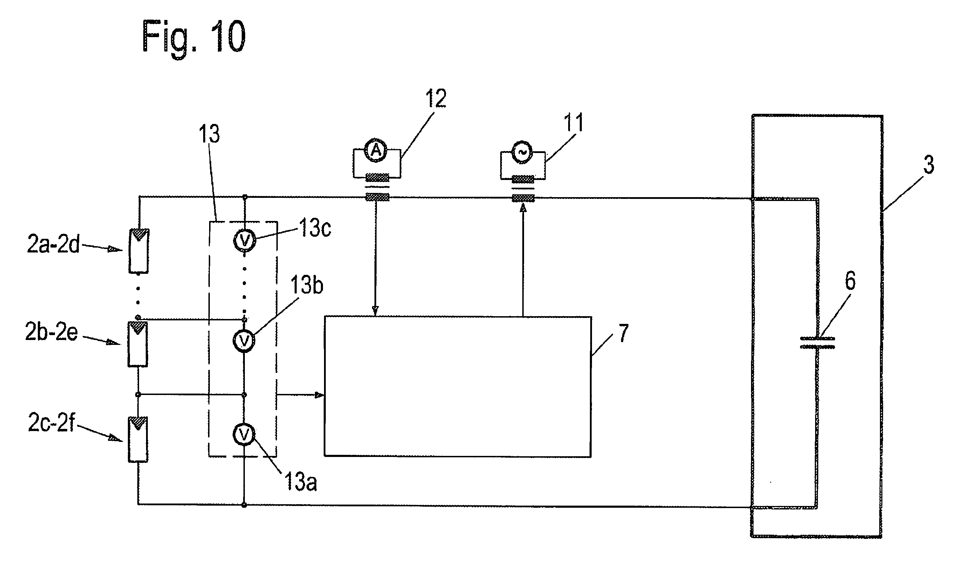

Schließlich ist in Fig. 10 eine Ausführung dargestellt, in welcher alle Photovoltaikmodule 2a bis 2f seriell in Form eines Strings angeordnet sind. Eine Unterteilung in separat überwachte Gruppen wird in diesem Ausführungsbeispiel durch die Anordnung der Spannungsmesseinrichtung 13 als Auskopplungsmittel erreicht. Die Spannungsmesseinrichtung 13 ist so angeschlossen, dass jeweils ein Spannungsmesser 13a, 13b, 13c einem Teilstring, gebildet durch die Photovoltaikmodule 2a-2d, 2b-2e und 2c-2f, zugeordnet ist und dessen jeweilige Spannung erfasst. Die Gruppen werden hier somit durch die Teilstrings gebildet.

Als weiteres, gemeinsames Auskopplungsmittel ist ein Stromwandler 12 vorgesehen. Auch das Einkopplungsmittel ist gemeinsam für alle Gruppen als Übertrager 11 ausgeführt. Dabei sind der Übertrager 11 und der Stromwandler 12 in Reihe in eine Verbindungsleitung zwischen den Wechselrichter 3 und den aus den Photovoltaikmodulen 2a-2f gebildeten String geschaltet.

Bei allen gezeigten Beispielen ist zudem zusätzlich möglich, die Auskoppelmittel auch unabhängig von einer Einspeisung des Testsignals auf das Vorliegen eines hochfrequenten Signals zu überwachen. Ein Lichtbogen, zum Beispiel entstehend an einem unzulänglichen elektrischen Kontakt, speist aufgrund von sich in seinem Plasma ausbildenden Schwingungen ein hochfrequentes Signal in den Strompfad ein. Das Vorliegen eines nicht auf eine Einspeisung des Testsignals zurückgehenden Hochfrequenzsignals lässt daher auf einen innerhalb einer Gruppe aufgetretenen Lichtbogen schließen. Dabei ist zum einen möglich, einen Lichtbogen zu detektieren, auch während ein Testsignal eingespeist wird, zum Beispiel wenn ein hochfrequentes Signal in einer Intensität detektiert wird, die über der Intensität liegt, die aufgrund eines eingespeisten Testsignals zu erwarten ist. Zum anderen ist denkbar, die Einspeisung des Testsignals in vorbestimmten Zeiträumen, beispielsweise periodisch, auszusetzen und in diesen Zeiträumen über die Auskoppelmittel das Auftreten eines hochfrequenten Signals innerhalb der Photovoltaikanlage zu überwachen.

Die Erfindung ist nicht auf die beschriebenen Ausführungsbeispiele beschränkt, die auf vielfache Weise abgewandelt werden können.

### Bezugszeichenliste

- Photovoltaikanlage: 1
- Photovoltaikgenerator: 2
- Photovoltaikmodule: 2a bis 2f
- Wechselrichter: 3
- Wechselstromersatzkapazität: 6
- Überwachungsvorrichtung: 7
- Einkopplungsweg: 8a, 8b
- Auskopplungsweg: 9a, 9b
- Kapazität: 10
- Einkopplungsmittel: 11
- Übertrager: 11a, 11b, 11c
- Auskopplungsmittel: 12, 13
- Stromwandler: 12, 12a, 12b, 12c
- Spannungsmesseinrichtung: 13
- Spannungsmesser: 13a, 13b, 13c
- Einkopplungsmittel: 15, 15a, 15b, 15c
- Sperrinduktivität: 16a, 16b, 16c
- Koppelkapazität: 17
- Sperrinduktivität: 18
- Auskopplungsmittel: 19
- Primärwicklungen: 19a, 19b, und 19c
- Sekundärwicklung: 19s
- Einkopplungsmittel: 20
- Sekundärwicklungen: 20a, 20b, und 20c
- Primärwicklung: 20p
- Schritt: 100, 100a-c; 200, 200a-c; 300

## Patentansprüche

1. Vorrichtung zur Überwachung einer Photovoltaikanlage (1) zur Erkennung des Auftretens von den bestimmungsgemäßen Betrieb der Photovoltaikanlage (1) beeinträchtigenden Ereignissen, umfassend:
- einen photovoltaischen Generator (2) mit einer ersten Gruppe von Photovoltaikmodulen (2a) und einer zweiten Gruppe von Photovoltaikmodulen (2b-f), die von der ersten Gruppe verschieden ist;
- einem ersten und einem zweiten Kopplungsmittelpaar, beide Paare umfassend Signaleinkopplungsmittel (11a-c, 17) zur Einkopplung eines Testsignals in den photovoltaischen Generator, und Signalauskopplungsmittel zur Auskopplung eines Antwortsignals, wobei
- das Signaleinkopplungsmittel (11a-c, 17) und/oder das Signalauskopplungsmittel des ersten Kopplungsmittelpaars derart angeordnet ist, dass das Auftreten der Ereignisse selektiv in der ersten Gruppe von Photovoltaikmodulen (2a) erkannt werden kann, und das Signaleinkopplungsmittel (11a-c, 17) und/oder das Signalauskopplungsmittel des zweiten Kopplungsmittelpaars derart angeordnet ist, dass das Auftreten der Ereignisse selektiv in der zweiten Gruppe von Photovoltaikmodulen (2b-f) erkannt werden kann,
**dadurch gekennzeichnet, dass**
das Signaleinkopplungsmittel (11a-c, 17) des ersten Kopplungsmittelpaars von dem durch die erste Gruppe von Photovoltaikmodulen (2a) fließenden Gleichstrom durchflossen wird und das Signaleinkopplungsmittel (11a-c, 17) des zweiten Kopplungsmittelpaars von dem durch die zweite Gruppe von Photovoltaikmodulen (2b-f) fließenden Gleichstrom durchflossen wird.

2. Vorrichtung nach Anspruch 1, wobei das Signalauskopplungsmittel des ersten Kopplungsmittelpaars von dem durch die ersten Gruppe von Photovoltaikmodulen (2a) fließenden Gleichstrom durchflossen wird und das Signalauskopplungsmittel des zweiten Kopplungsmittelpaars von dem durch die zweite Gruppe von Photovoltaikmodulen (2b-f) fließenden Gleichstrom durchflossen wird.

3. Vorrichtung nach Anspruch 1 oder 2, wobei das Signaleinkopplungsmittel (11, 17) des ersten Kopplungsmittelpaares identisch mit dem Signaleinkopplungsmittel (11, 17) des zweiten Kopplungsmittelpaares ist.

4. Vorrichtung nach Anspruch 2, wobei das Signalauskopplungsmittel des ersten Kopplungsmittelpaares identisch mit dem Signalauskopplungsmittel des zweiten Kopplungsmittelpaares ist.

5. Vorrichtung nach einem der vorstehenden Ansprüche, wobei das Signalauskopplungsmittel einen Stromwandler (12, 12a-c) umfasst.

6. Vorrichtung nach einem der vorstehenden Ansprüche, wobei das Signalauskopplungsmittel eine Spannungsmesseinrichtung (13) umfasst.

7. Vorrichtung nach Anspruch 6, wobei die erste und die zweite Gruppe von Photovoltaikmodulen (2a, 2b-f) reihenverschaltet sind und wobei die Spannungsmesseinrichtung (13) den verschiedenen Gruppen zugeordnete Spannungsmesser (13a-c) aufweist.

8. Vorrichtung nach einem der vorstehenden Ansprüche, wobei das Signaleinkopplungsmittel einen Übertrager (11, 11a-c) umfasst.

9. Vorrichtung nach einem der vorstehenden Ansprüche, wobei das Signaleinkopplungsmittel einen kapazitiven Einkoppler (17, 17a-c) umfasst.

10. Vorrichtung nach einem der vorstehenden Ansprüche, weiterhin umfassend eine mit dem ersten und zweiten Kopplungsmittelpaares verbundenen Überwachungsvorrichtung (7) zur Erzeugung des Testsignals und zur Auswertung des Antwortsignals, wobei die Auswertung der Signale des ersten und zweiten Kopplungsmittelpaares getrennt erfolgt.

11. Vorrichtung nach Anspruch 10, wobei die Überwachungsvorrichtung (7) zur Erzeugung eines dem jeweiligen Kopplungsmittelpaares zuordenbaren Warnsignals eingerichtet ist, wenn eine alterungsspezifische Eigenschaft, insbesondere ein Widerstandswert, der diesem Kopplungsmittelpaares zugeordneten Gruppe von Photovoltaikmodulen (2a-f) einen vorbestimmten Wert übersteigt.

12. Verfahren zur Überwachung einer eine Anzahl von wenigstens zwei oder mehr Photovoltaikmodule (2a-f) aufweisenden Photovoltaikanlage (1) zur Erkennung des Auftretens von den bestimmungsgemäßen Betrieb der Photovoltaikanlage beeinträchtigenden Ereignissen,
- wobei die Photovoltaikanlage (1) mit wenigstens einem elektrischen Testsignal angeregt wird, das mit wenigstens einem Einkopplungsmittel in die Photovoltaikanlage (1) eingekoppelt wird - Schritt 100 -,
- wobei wenigstens ein Antwortsignal der Photovoltaikanlage (1) auf die Anregung mit wenigstens einem Auskopplungsmittel aus der Photovoltaikanlage (1) ausgekoppelt wird - Schritt 200 -,
- wobei das Antwortsignal der Photovoltaikanlage (1) auf die Anregung erfasst wird und zur Erkennung des Auftretens wenigstens eines den bestimmungsgemäßen Betrieb der Photovoltaikanlage (1) beeinträchtigenden Ereignisses ausgewertet wird - Schritt 300 - ,
- wobei die wenigstens zwei oder mehr Photovoltaikmodule (2a-f) in wenigstens zwei oder mehr Gruppe unterteilt werden,
- und wobei jede der Gruppen auf das Auftreten eines den bestimmungsgemäßen Betrieb der Photovoltaikanlage (1) beeinträchtigenden Ereignisses überwacht wird,
**dadurch gekennzeichnet, dass**
- das Einkopplungsmittel von dem durch die Photovoltaikmodule (2a-2f) der jeweiligen Gruppen fließenden Gleichstrom durchflossen wird.

13. Verfahren nach Anspruch 12, **dadurch gekennzeichnet, dass** entweder einer oder beide der Schritte 100 und 200 je Gruppe separat durchgeführt werden.

14. Verfahren nach Anspruch 12 oder 13, **dadurch gekennzeichnet, dass** bei der Unterteilung der zwei oder mehr Photovoltaikmodule (2a-f) in wenigstens zwei oder mehr Gruppen wenigstens eine der Gruppen oder mehrere der Gruppen von zwei oder mehr in Reihe geschaltete und/oder parallel geschaltete Photovoltaikmodule aufweisen.

15. Verfahren nach einem der Ansprüche 12 bis 14, **dadurch gekennzeichnet, dass** für wenigstens zwei der Gruppen ein gemeinsames Einkopplungsmittel und/oder ein gemeinsames Auskoppelmittel verwendet wird.

16. Verfahren nach einem der Ansprüche 12 bis 15, **dadurch gekennzeichnet, dass** die Einkopplung des Testsignals und/oder die Auskopplung der Signalantwort galvanisch getrennt vorgenommen wird.

17. Verfahren nach einem der Ansprüche 12 bis 16, **dadurch gekennzeichnet, dass** das Verfahren zur Erkennung eines innerhalb der Photovoltaikanlage (1) auftretenden Lichtbogens eingesetzt wird.

## Claims

1. A device for monitoring a photovoltaic system (1) to detect the occurrence of events impairing normal operation of the photovoltaic system (1), the device comprising:
- a photovoltaic generator (2) comprising a first group of photovoltaic modules (2a) and a second group of photovoltaic modules (2b-f) being different from the first group;
- a first and a second pair of coupling means, both pairs comprising signal coupling-in means (11 a-c, 17) for coupling a test signal into the photovoltaic generator, and a signal coupling-out means (12a-c, 13a-c) for coupling out a response signal, wherein
- the signal coupling-in means (11a-c, 17) and/or the signal coupling-out means of the first pair of coupling means is arranged to selectively detect the occurrence of the events in the first group of photovoltaic modules (2a), and the signal coupling-in means (11 a-c, 17) and/or the signal coupling-out means of the second pair of coupling means is arranged to selectively detect the occurrence of the events in the second group of photovoltaic modules (2b-f),
**characterized in that**
the DC current of the first group of photovoltaic modules (2a) flows through the signal coupling-in means (11 a-c, 17) of the first pair of coupling means, and the DC current of the second group of photovoltaic modules (2b-f) flows through the signal coupling-in means (11a-c, 17) of the second pair of coupling means.

2. The device as claimed in claim 1, wherein a DC current of the first group of photovoltaic modules (2a) flows through the signal coupling-out of the first pair of coupling means, and a DC current of the second group of photovoltaic modules (2b-f) flows through the signal coupling-out means of the second pair of coupling means.

3. The device as claimed in claim 1 or 2, wherein the signal coupling-in means (11, 17) of the first pair of coupling means are identical to the signal coupling-in means (11, 17) of the second pair of coupling means.

4. The device as claimed in claim 2, wherein the signal coupling-out means of the first pair of coupling means are identical to the signal coupling-out means of the second pair of coupling means.

5. The device as claimed in one of the preceding claims, wherein the signal coupling-out means comprise a current transformer (12, 12a-c).

6. The device as claimed in one of the preceding claims, wherein the signal coupling-out means comprise a voltage measuring device (13).

7. The device as claimed in claim 6, the first and second groups of photovoltaic modules (2a, 2b-f) being connected in series, and the voltage measuring device (13) comprising voltmeters (13a-c) assigned to different ones of the groups.

8. The device as claimed in one of the preceding claims, wherein the signal coupling-in means comprise a transformer (11, 11 a-c).

9. The device as claimed in one of the preceding claims, the signal coupling-in means comprising a capacitive coupling-in element (17, 17a-c).

10. The device as claimed in one of the preceding claims, further comprising a monitoring device (7) connected to the first and second pairs of coupling means and configured to generate the test signal and configured to evaluate the response signal, wherein the signals from the first and second pairs of coupling means are evaluated separately.

11. The device as claimed in claim 10, the monitoring device (7) being configured to generate a warning signal corresponding to a respective one of pair of coupling means, if an aging-specific property, in particular a resistance value, of the group of photovoltaic modules (2a-f) assigned to the respective pair of coupling means exceeds a predetermined value.

12. A method of monitoring a photovoltaic system (1) with a number of at least two or more photovoltaic modules (2a-f) to detect the occurrence of events impairing normal operation of the photovoltaic system,
- wherein the photovoltaic system (1) is excited with at least one electrical test signal coupled into the photovoltaic system (1) using at least one coupling-in means - step 100 -,
- wherein at least one excitation response signal is coupled out from the photovoltaic system (1) using at least one coupling-out means - step 200 -,
- wherein the excitation response signal of the photovoltaic system (1) is determined and evaluated to detect the occurrence of at least one event impairing the normal operation of the photovoltaic system (1) - step 300 -,
- wherein the at least two or more photovoltaic modules (2a-f) are divided into at least two or more groups,
- and wherein each of the groups being monitored for the occurrence of an event impairing the normal operation of the photovoltaic system (1), **characterized in that**
- DC currents of the photovoltaic modules (2a-f) of the groups flow through the corresponding coupling-in means.

13. The method as claimed in claim 12, **characterized in that** one or both of steps 100 and 200 are carried out separately for each group.

14. The method as claimed in claim 12 or 13, **characterized in that** when dividing the at least two or more photovoltaic modules (2a-f) into at least two or more groups, at least one of the groups or a plurality of the groups comprises two or more photovoltaic modules connected in series and/or in parallel.

15. The method as claimed in one of claims 12 to 14, **characterized in that** a common coupling-in means and/or a common coupling-out means is used for at least two of the groups.

16. The method as claimed in one of claims 12 to 15, **characterized in that** at least one of the coupling-in of the test signal and the coupling-out of the signal response is carried out in a galvanically isolated manner.

17. The method as claimed in one of claims 12 to 16, **characterized in that** the method is applied to detect an arc occurring inside the photovoltaic system (1).

## Revendications

1. Dispositif de surveillance d'une installation photovoltaïque (1) pour permettre de se rendre compte de la présence d'évènements de nature à perturber le fonctionnement correct de l'installation photovoltaïque (1) comprenant :
- un générateur photovoltaïque (2) comprenant un premier groupe de modules photovoltaïques (2a) et un second groupe de modules photovoltaïques (2b-f) différent du premier groupe,
- une première et une seconde paires de moyens de couplage, ces deux paires comprenant des moyens de couplage de signal (11a-c, 17) pour permettre de coupler un signal test dans le générateur photovoltaïque et des moyens de découplage de signal pour permettre de découpler un signal de réponse, dans lequel
- les moyens de couplage de signal (11a-c, 17) et/ou les moyens de découplage de signal de la première paire de moyens de couplage sont positionnés de sorte que la présence de l'évènement puisse être reconnue sélectivement dans le premier groupe de modules photovoltaïques (2a) et les moyens de couplage de signal (11a-c, 17) et/ou les moyens de découplage de signal de la seconde paire de moyens de couplage sont positionnés de sorte que la présence de l'évènement puisse être reconnue sélectivement dans le second groupe de modules photovoltaïques (2b-f),
**caractérisé en ce que**
les moyens de couplage de signal (11a-c, 17) de la première paire de moyens de couplage sont parcourus par le courant continu circulant dans le premier groupe de modules photovoltaïques (2a) et les moyens de couplage de signal (11a-c, 17) de la seconde paire de moyens de couplage sont parcourus par le courant continu circulant dans le second groupe de modules photovoltaïques (2b-f).

2. Dispositif conforme à la revendication 1, dans lequel les moyens de découplage de signal de la première parie de moyens de couplage sont parcourus par le courant continu circulant dans le premier groupe de modules photovoltaïques (2a) et les moyens de découplage de signal de la seconde paire de moyens de couplage sont parcourus par le courant continu circulant dans le second groupe de modules photovoltaïques (2b-f).

3. Dispositif conforme à la revendication 1 ou 2, dans lequel les moyens de couplage de signal (11, 17) de la première paire de moyens de couplage sont identiques aux moyens de couplage de signal (11, 17) de la seconde paire de moyens de couplage.

4. Dispositif conforme à la revendication 2, dans lequel les moyens de découplage de signal de la première paire de moyens de couplage sont identiques aux moyens de découplage de signal de la seconde paire de moyens de couplage.

5. Dispositif conforme à l'une des revendications précédentes, dans lequel les moyens de découplage de signal comprennent un transformateur de courant (12, 12 a-c).

6. Dispositif conforme à l'une des revendications précédentes, dans lequel les moyens de découplage de signal comprennent un dispositif de mesure de tension (13).

7. Dispositif conforme à la revendication 6, dans lequel le premier groupe et le second groupe de modules photovoltaïques (2a, 2b-f) sont montés en série et le dispositif de mesure de tension (13) comprend des voltmètres (13a-c) associées aux différents groupes.

8. Dispositif conforme à l'une des revendications précédentes, dans lequel les moyens de couplage de signal comprennent un émetteur (11, 11a-c).

9. Dispositif conforme à l'une des revendications précédentes, dans lequel les moyens de couplage de signal comprennent coupleur capacitif (17, 17a-c).

10. Dispositif conforme à l'une des revendications précédentes, comprenant en outre un dispositif de surveillance (7) relié à la première et à la seconde paire de moyens de couplage pour permettre de produire le signal test et d'exploiter le signal de réponse, l'exploitation des signaux de la première et de la seconde paires de moyens de couplage s'effectuant séparément.

11. Dispositif conforme à la revendication 10, dans lequel le dispositif de surveillance (7) est conçu pour produire un signal d'alerte pouvant être associé à une paire de moyens de couplage respective lorsqu'une propriété spécifique du vieillissement, en particulier une valeur de résistance du groupe de modules photovoltaïques (2a-f) associé à cette paire de moyens de couplage dépasse une valeur prédéfinie.

12. Dispositif de surveillance d'une installation photovoltaïque (1) comprenant un nombre d'au moins deux ou un nombre supérieur de modules photovoltaïques (2a-f) pour permettre de se rendre compte de la présence d'évènements perturbant le fonctionnement correct de l'installation photovoltaïque, selon lequel :
- l'installation photovoltaïque (1) est excitée par au moins un signal test électrique qui est couplé à au moins des moyens de couplage dans l'installation photovoltaïque (1) - étape 100 -,
- au moins un signal de réponse de l'installation photovoltaïque (1) à l'excitation est découplé de l'installation photovoltaïque (1) par au moins des moyens de découplage - étape 200 -,
- le signal de réponse de l'installation photovoltaïque (1) à l'excitation est détecté et exploité pour se rendre compte de la présence d'au moins un évènement perturbant le fonctionnement correct de l'installation photovoltaïque (1) - étape 300 -,
- les modules photovoltaïques (2a-f) sont subdivisés en au moins deux ou un plus grand nombre de groupes, et
- chacun de ces groupes est surveillé pour se rendre compte de la présence d'un évènement perturbant le fonctionnement correct de l'installation photovoltaïque (1),
**caractérisé en ce que**
les moyens de découplage sont parcourus par le courant continu circulant dans les modules photovoltaïques (2a-2f) des groupes respectifs.

13. Procédé conforme à la revendication 12,
**caractérisé en ce que**
au moins l'une des deux étapes 100 et 200 est mise en oeuvre séparément pour chaque groupe.

14. Procédé conforme à la revendication 12 ou 13,
**caractérisé en ce que**
lors de la subdivision des modules photovoltaïques (2a-f) en au moins deux ou un plus grand nombre de groupes, au moins l'un des groupes ou plusieurs des groupes comportent deux ou un plus grand nombre de modules photovoltaïques montés en série et/ou en parallèle.

15. Procédé conforme à l'une des revendications 12 à 14,
**caractérisé en ce que**
pour au moins deux des groupes on utilise des moyens de couplage communs et/ou des moyens de découplage communs.

16. Procédé conforme à l'une des revendications 12 à 15,
**caractérisé en ce que**
le couplage du signal test et/ou le découplage de la réponse de signal est(sont) mis en oeuvre séparément de manière galvanique.

17. Procédé conforme à l'une des revendications 12 à 16,
**caractérisé en ce que**
le procédé est mis en oeuvre pour se rendre compte de la présence d'un arc électrique dans l'installation photovoltaïque (1).
